Europäisches Patentamt

European Patent Office

Office européen des brevets

(11) Publication number: **0 468 630 A2**

# EUROPEAN PATENT APPLICATION

(21) Application number: **91305235.3**

(22) Date of filing: **11.06.91**

(51) Int. Cl.5: **H01L 21/336**, H01L 21/82, H01L 29/784

(30) Priority: **27.07.90 US 558704**

(43) Date of publication of application:
**29.01.92 Bulletin 92/05**

(84) Designated Contracting States:
**AT BE CH DE ES FR GB GR IT LI LU NL SE**

(71) Applicant: **ACTEL CORPORATION**
**955 East Arques Avenue**
**Sunnyvale California 94086(US)**

(72) Inventor: **Eltoukhy, Abdelshafy A.**
**509 Churchill Park Drive**
**San Jose, California 95136(US)**
Inventor: **McCollum, John L.**
**19810 Merribrook Drive**
**Saratoga, California 95070(US)**
Inventor: **Bakker, Gregory W.**
**735 Lakefair Drive**
**Sunnyvale, California 94089(US)**

(74) Representative: **Williams, Trevor John**
**J.A. KEMP & CO. 14 South Square Gray's Inn**
**London WC1R 5LX(GB)**

(54) **Method of increasing the breakdown voltage of a MOS transistor without changing the fabrication process.**

(57) The breakdown voltage of a MOSFET transistor is increased by reducing the electric field at the gate edge and/or at the field oxide edge. The electric field is reduced by moving the N+ source/drain implant away from the gate or field edge by altering the geometry of the N+ source/drain implant mask already used in the process. Diffusion continuity to the gate and field edges is maintained by a N- implant. A MOSFET transistor device having enhanced high voltage characteristics includes heavily doped source and drain regions spaced apart from both the gate edge and the field oxide edge. Lightly doped regions contiguous with the heavily doped source and drain regions extend from the edges of the heavily doped regions to both the gate and the field oxide edges. Another MOSFET transistor device having enhanced high voltage characteristics includes heavily doped source and drain regions spaced apart from the gate edge. Lightly doped regions contiguous with the heavily doped source and drain regions extend from the edges of the heavily doped regions to the gate edges. Another MOSFET transistor device having enhanced high voltage characteristics includes heavily doped source and drain regions spaced apart from the field oxide edge. Lightly doped regions contiguous with the heavily doped source and drain regions extend from the edges of the heavily doped regions to the field oxide edges.

FIG.-1

The present invention relates to semiconductor devices. In particular, the present invention relates to field effect transistors with enhanced voltage breakdown characteristics.

## 2. The Prior Art

In numerous applications, certain devices integrated into a semiconductor integrated circuit must be able to withstand higher voltages than other devices in the same circuit. For example, programmable elements such as antifuses, EPROMs and EEPROMs require programming voltages (i.e. 15-20v) which are higher than the breakdown voltages of other devices integrated into a circuit with them fabricated using a standard CMOS process.

The need for high voltage transistors used in the programming path for programmable elements is one particular example. A standard 5 volt MOS transistor is optimized to give the maximum drive current without being affected by some high electric field phenomena, such as hot electron effects, that degrade the transistor in both threshold voltage and driving current during its lifetime. Hot electron effects are mainly due to the high electric field located underneath the gate at the drain side.

In order to integrate the programmable element with other devices in a standard process, ways must be found to accommodate the high voltage requirements of the devices which supply the programming voltage. The mechanisms known to the inventors for increasing high voltage characteristics all require modifications to one or more process modules in the fabrication process, thus rendering the process non-standard. In addition, such process modifications alter certain other characteristics of all of the devices in the integrated circuit, which may be disadvantageous in certain applications.

In order to reduce the electric field present at the edges of the diffused regions in the semiconductor substrate, common processes known as lightly doped drain (LDD), and double diffused drain (DDD) are used in prior art devices. In the LDD process, a lightly doped implant is performed after the polysilicon etch for gate definition, using the defined gate as a mask. An oxide spacer is then formed on the sidewall of the polysilicon gate. A high dose source/drain implant is then performed using the spacer as a mask. This implant reduces the parasitic resistance of the device and forms low resistance contacts to the metal layer. The DDD process is similar, but the implants do not straddle the spacer step.

The spacer used on the outer edges of the polysilicon gates in the conventional LDD process leads to a reduction in the driving current of the transistor. A minimum-sized spacer width is usually used in order to minimize the parasitic resistance of the device as long as the lower electric field required to decrease the hot electron effects is achieved. The resultant electric field may be low enough for 5 volt operation but may not be low enough to sustain high voltage on the drain. High voltage breakdown may be caused by the lateral diffusion of the high dose source/drain implant leading to higher electric field intensity at the gate edge. The breakdown of the drain with the gate grounded is known as gate aided breakdown, and is usually less than the junction breakdown.

In order to prevent the heavily doped source/drain implant from getting underneath the gate, one could alter the LDD process so that a wider spacer is formed. This approach will lead to degradation in the driving current of the low voltage transistors and hence to a much slower circuit. Also this will require a change in the spacer process which may not be compatible with other products made using the same process.

Ordinary junction breakdown may also limit the voltage that a device can withstand. Usually junction breakdown occurs at the field oxide edge of a diffusion. At the edge, the electric field is higher than in the planar area of the diffusion because of junction curvature and/or the presence of a field implant, sometimes called a channel stop implant, under the field oxide adjacent to the diffusion.

In some situations, improving the high voltage breakdown characteristics of certain transistors in a circuit by introduction of variations on existing steps or providing additional steps in the fabrication process are impractical, such as where the circuit containing the device is to be fabricated by a silicon foundry utilizing a standard process, or where the processing changes which alter the breakdown voltage characteristics of the target device will alter the performance of other devices on the semiconductor substrate in an undesired and deleterious manner. There is thus a need for a way in which to improve the high voltage characteristics of selected transistors on a semiconductor substrate without need to resort to altering the fabrication process.

## BRIEF DESCRIPTION OF THE INVENTION

The present invention increases the breakdown voltage of a MOSFET transistor by reducing the electric field at the gate edge and/or at the field oxide edge. The electric field is reduced by moving the N+ source drain implant away from the gate or field edge by altering the geometry of the N+ source/drain implant mask already used in the process. Diffusion continuity to the gate and field edges is maintained by the N- LDD or DDD implant already used in the process.

In a first embodiment of the present invention, a MOSFET transistor device having enhanced high voltage characteristics includes heavily doped source and drain regions spaced apart from both the gate edge and the field oxide edge. Lightly doped regions contiguous with the heavily doped source and drain regions extend from the edges of the heavily doped regions to both the gate and the field oxide edges.

In a second embodiment of the present invention, a MOSFET transistor device having enhanced high voltage characteristics includes heavily doped source and drain regions spaced apart from the gate edge. Lightly doped regions contiguous with the heavily doped source and drain regions extend from the edges of the heavily doped regions to the gate edges.

In a third embodiment of the present invention, a MOSFET transistor device having enhanced high voltage characteristics includes heavily doped source and drain regions spaced apart from the field oxide edge. Lightly doped regions contiguous with the heavily doped source and drain regions extend from the edges of the heavily doped regions to the field oxide edges.

BRIEF DESCRIPTION OF THE DRAWINGS

FIG. 1 is a cross-sectional view across the channel length of a field effect transistor device according to the prior art.

FIG. 2 is a top view of the device depicted in FIG. 1.

FIG. 3 is a cross-sectional view across the channel length of a field effect transistor device according to a first presently preferred embodiment of the invention.

FIG. 4 is a top view of the device depicted in FIG. 3.

FIG. 5 is a cross-sectional view across the channel length of a field effect transistor device according to a second presently preferred embodiment of the invention.

FIG. 6 is a top view of the device depicted in FIG. 5.

FIG. 7 is a cross-sectional view across the channel length of a field effect transistor device according to a third presently preferred embodiment of the invention.

FIG. 8 is a top view of the device depicted in FIG. 7.

DETAILED DESCRIPTION OF A PREFERRED EMBODIMENT

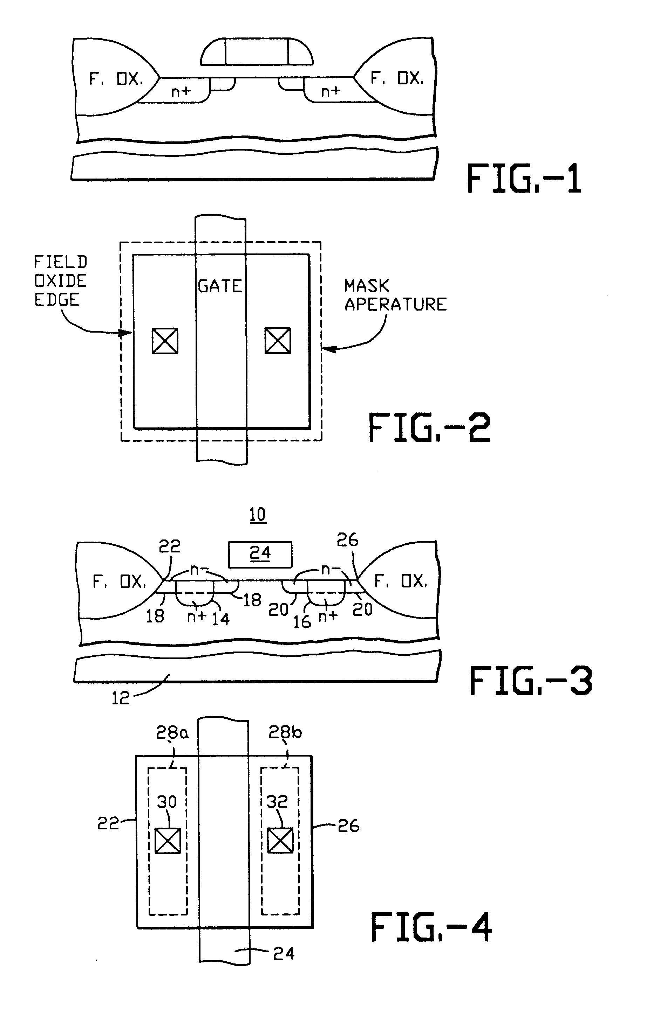

FIG. 1 is a cross-sectional view across the channel length of a prior art field effect transistor device employing an LDD structure. A lightly-doped implant is performed after the polysilicon etch which defines the gate edges, using the defined gate as a mask. An oxide spacer is then formed on the sidewall of the polysilicon gate. A high dose source/drain implant is then performed using the spacer as a mask. This implant reduces the parasitic resistance of the device and forms low resistance contacts to the metal layer.

Referring now to FIG. 2, a top view of the prior art device depicted in FIG. 1, it can be seen that the mask used to perform the source/drain implant includes a single aperture which extends to or beyond the field oxide edge. The N+ implant exists near the polysilicon gate edge, thus causing a high field at that region. That high field can cause gate aided breakdown. In addition, the N+ implant adjacent to the p-type channel stop implant can cause a high field to exist in the region of that implant and the p-type channel stop implant, which may cause junction breakdown between the N+ implant and the field stop implant.

The approach employed by the present invention to solving the problem without requiring alteration of the fabrication process includes performing the heavy source/drain implant through a mask having an aperture or apertures which locates the edge of the implant further away from the edge of the polysilicon gate. This solution requires only a change in geometry of the source/drain implant mask and does not require any extra or different process steps. In circuit applications where high voltage is present only on the drain, the geometry change can be implemented only on the drain side of the high voltage transistors. By use of this technique, which, unlike the conventional LDD structures, does not require the use of spacers, the drain breakdown voltage of the transistor can be increased almost to the junction breakdown allowed by the process.

The voltage at which junction breakdown at the field edge occurs can be improved by employing a mask which locates the heavy source/drain implant away from the field edge. This is similar to implanting the high dose region away from the drain gate edge. Again no additional masks are required, this change being simultaneously implementable by locating the aperture edge of the source drain implant mask closest to the field edge further from that edge.

The present approach is particularly suited to a process which includes an LDD structure such as that shown in FIGS. 1 and 2. The offset of the heavily doped regions from the edge of the field oxide reduces the electric field at these points by separating the heavily doped regions from the field implant. Such placement also reduces the junction edge curvature if LDD implants are used. It should be understood by those of ordinary skill in the art that this invention is easily practiced in a process which does not employ LDD as long as an step for performing an implant lighter in dose than the source/drain implant is employed.

Referring now to FIG. 3, a device according to a first presently preferred embodiment of the invention reduces the likelihood that either the gate-aided or junction breakdown mechanism which may plague devices such as those depicted in FIGS. 1 and 2 will take place. FIG. 3 is a cross-sectional view across the channel length of a field effect transistor device according to a presently preferred embodiment of the invention.

The device 10 of FIG. 3 is fabricated in a semiconductor substrate 12 and includes spaced apart heavily doped source and drain regions 14 and 16, preferably formed by ion implantation of a relatively high concentration of a desired dopant species. More lightly doped regions 18 and 20 are also disposed in the semiconductor substrate. Lightly doped region 18 is contiguous with source region 14 and lightly doped region 20 is contiguous with region 16. Lightly doped region 18 extends from the edge of the field at the birds beak tip 22 to a point just under the edge of the gate 24. Lightly doped region 20 extends from the edge of the field at the birds beak tip 26 to a point just under the edge of the gate 24.

Referring now to FIG. 4, a top view of the device depicted in FIG. 3, it may be seen that the mask employed for performing the heavy source/drain implant of device 10 includes two symmetrical apertures 28a and 28b. The position of the mask when in place is indicated by the relative placement of the apertures 28a and 28b with respect to gate 24. The positions of source and drain contacts 30 and 32 are also shown in FIG. 4.

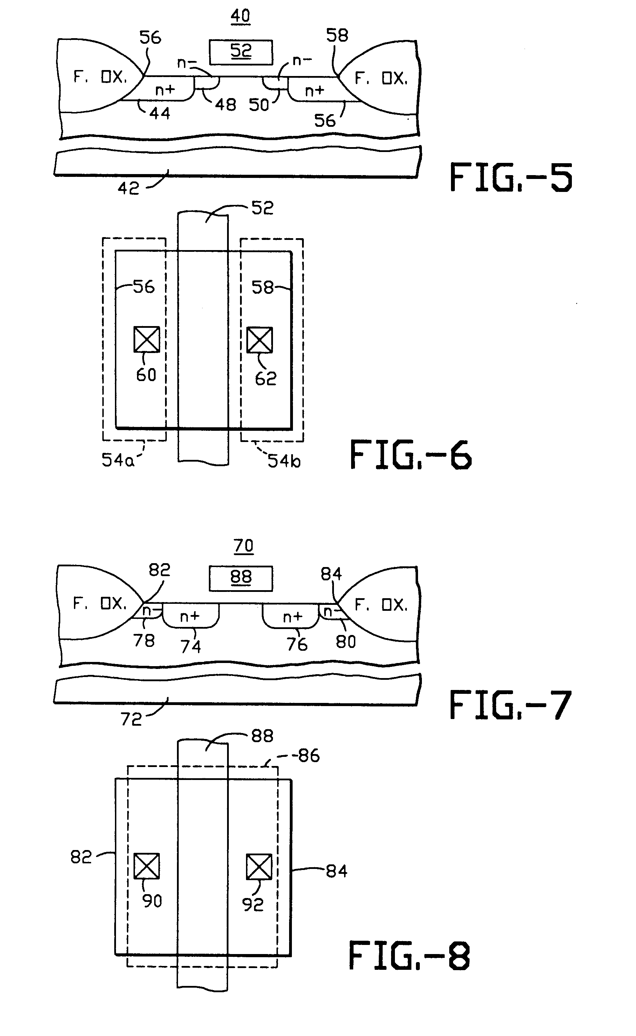

Referring now to FIG. 5, a device according to a second presently preferred embodiment of the invention reduces the likelihood that the gate-aided breakdown mechanism which may plague devices such as those depicted in FIGS. 1 and 2 will take place. FIG. 5 is a cross-sectional view across the channel length of a field effect transistor device according to a presently preferred embodiment of the invention.

The device 40 of FIG. 5 is fabricated in a semiconductor substrate 42 and includes spaced apart heavily doped source and drain regions 44 and 46, preferably formed by ion implantation of a relatively high concentration of a desired dopant species. More lightly doped regions 48 and 50 are also disposed in the semiconductor substrate. Lightly doped region 48 is contiguous with source region 44 and lightly doped region 50 is contiguous with drain region 46. Lightly doped region 48 is co-extensive with and extends from the edge of the heavy source implant 44 to a point just under the edge of the source side of gate 52. Lightly doped region 50 is co-extensive with and extends from the edge of the heavy implant 46 to a point just under the edge of the drain side of gate 52.

Referring now to FIG. 6, a top view of the device depicted in FIG. 5, it may be seen that the mask employed for performing the heavy source/drain implant of device 40 includes two symmetrical apertures 54a and 54b. The position of the mask when in place is indicated by the relative placement of the apertures 54a and 54b with respect to gate 52 and field oxide edges 56 and 58. The positions of source and drain contacts 60 and 62 are also shown in FIG.6.

Referring now to FIG. 7, a device according to a third presently preferred embodiment of the invention reduces the likelihood that the junction breakdown mechanism which may plague devices such as those depicted in FIGS. 1 and 2 will take place. FIG. 7 is a cross-sectional view across the channel length of a field effect transistor device according to a presently preferred embodiment of the invention.

The device 70 of FIG. 7 is fabricated in a semiconductor substrate 72 and includes spaced apart heavily doped source and drain regions 74 and 76, preferably formed by ion implantation of a relatively high concentration of a desired dopant species. More lightly doped regions 78 and 80 are also disposed in the semiconductor substrate. Lightly doped region 78 is contiguous with heavily doped source region 74 and lightly doped region 80 is contiguous with heavily doped drain region 76. Lightly doped region 78 is co-extensive with and extends from the edge of the heavily doped source region 74 to a point just under the edge of the field oxide defined by the birds beak tip 82. Lightly doped region 80 is co-extensive with and extends from the edge of the heavily doped drain region 76 to a point just under the edge of the field oxide defined by the birds beak tip 84.

Referring now to FIG. 8, a top view of the device depicted in FIG. 6, it may be seen that the mask employed for performing the heavy source/drain implant of device 70 includes an aperture 86, which, when the mask is in place, is symmetrical about gate 88. The positions of source and drain contacts 90 and 92 are also shown in FIG. 8.

As will be recognized by those of ordinary skill in the art, several design procedures and rules need to be taken into consideration when designing a high voltage transistor with an offset mask aperture or apertures like those depicted in FIGS. 3-8. First, the offset distance from the gate edge has to be long enough to guarantee that source/drain implant will not diffuse underneath the gate even with the worst case of mask misalignment. Second, it is possible to only use the offset mask only on the drain side to minimize the parasitic resistance if the source side does not get exposed to high voltage. Third, the overlap of contacts by the high dose source/drain implant must have enough margin to guarantee low contact resistance. Fourth, the width of the new high voltage device has to increase to compensate for the reduction in the driving current, due to the extra resistance associated with the offset mask. All of the above requirements can be easily accommodated in the design and is much easier to implement than changing the standard process steps especially if the low voltage transistors has to be compatible with other products.

Increase of the junction breakdown of diffusions by this method may be applied to any junction; it is not limited to transistors as shown in Figure 2. Methods described here are applicable to both N and P transistors and junctions.

Distance from the heavy dose source/drain implant to the field oxide edge and to the metal contacts must be chosen to achieve high breakdown voltage and good contacts with the worst case misalignment.

The devices 10, 40, and 70 of FIGS. 3-8 may be fabricated using conventional processing techniques without need to alter the normal process sequence. The active areas on the semiconductor wafer are first defined and the field oxide regions formed using conventional process steps. Next, the gate oxide layer is formed and then the gate is formed and defined using conventional processing steps. The light implant may then be performed using the gate and field edges as a mask, followed by the conventional source/drain implant masking and heavy source drain implant steps.

While a presently-preferred embodiment of the invention has been disclosed, those of ordinary skill in the art will, from an examination of the within disclosure and drawings be able to configure other embodiments of the invention. For instance, while the invention has been disclosed with respect to N-channel transistors, those of ordinary skill in the art will readily recognize that it is equally applicable to P-channel transistors. These other embodiments are intended to fall within the scope of the present invention which is to be limited only by the scope of the appended claims.

## Claims

1. A method of improving the high voltage breakdown characteristics of a MOS transistor in a lightly doped drain process including the step of providing for use in the source/drain implant step of a semiconductor fabrication process a mask having an aperture for said MOS transistor, said aperture having a size chosen such that the edge of the implanted region created by the use of such mask lies inside the active region away from the edges off the field oxide regions defining said MOS transistor.

2. A method of improving the high voltage breakdown characteristics of a MOS transistor in a lightly doped drain process including the step of providing for use in the source/drain implant step of a semiconductor fabrication process a mask having two apertures for said MOS transistor, said apertures arranged to create implant windows on either side of the polysilicon gate associated with said MOS transistor and each aperture having a size chosen such that the edge of the implanted region created by the use of such mask lies outside of and away from the edge of said polysilicon gate.

3. A method of improving the high voltage breakdown characteristics of a MOS transistor in a lightly doped drain process including the step of providing for use in the source/drain implant step of a semiconductor fabrication process a mask having two apertures for said MOS transistor, said apertures arranged to create implant windows on either side of the polysilicon gate associated with said MOS transistor and each aperture having a size chosen such that a first edge of the implanted region created by the use of such mask lies outside of and away from the edge of said polysilicon gate and a second edge of said implanted region lies inside the active region away from the edges of the field oxide regions defining said MOS transistor.

**FIG.-1**

FIELD OXIDE EDGE

GATE

MASK APERATURE

**FIG.-2**

10

24

22

26

n-

n-

F. OX.

F. OX.

18

18

20

20

n+ 14

16 n+

12

**FIG.-3**

28a

28b

30

32

22

26

24

**FIG.-4**

FIG.-5

FIG.-6

FIG.-7

FIG.-8